# EUROPEAN PATENT APPLICATION

(11) **EP 3 193 140 A1**
(43) Date of publication of application: **19.07.2017**
(21) Application number: 16305035.4
(22) Date of filing: 15.01.2016
(51) Int. Cl.: G01D 4/00, G01R 19/25, G01R 21/133

(54) **METHOD AND APPARATUS FOR SWITCH ON/OFF IMPULSE DETECTION**

(71) Applicant: Thomson Licensing, 92130 Issy-les-Moulineaux (FR)
(72) Inventor: LE NAOUR, Jean-Yves, 35576 Cesson-Sévigné (FR); LOUZIR, Ali, 35576 Cesson-Sévigné (FR); KUMAR, Rupesh, 35576 Cesson-Sévigné (FR)
(74) Representative: Huchet, Anne

(57) **Abstract**

An apparatus for switch ON/OFF impulse detection includes an impulse detector (210) and a microcontroller (240). The microcontroller is coupled in signal communication to the impulse detector (210). The impulse detector (210) is operative to receive an impulse response from an antenna (220). The impulse detector (210) is operative to provide one of a single alert signal and a plurality of alert signals for the microcontroller (240) in response to the impulse response. The impulse response includes one of a single impulse waveform and a plurality of impulse waveforms. The impulse detector (210) generates the single alert signal when the impulse response includes the single impulse waveform. The impulse detector (210) generates the plurality of alert signals when the impulse response includes respective ones of the plurality of impulse waveforms. The microcontroller (240) is operative to determine a nature of the impulse response. The nature is determined as a switch-ON response when the single alert signal is received. The nature is determined as a switch-OFF response when the plurality of alert signals are received.

## Description

### BACKGROUND OF THE INVENTION

### Field of the Invention

The present principles generally relate to electrical activity sensor apparatuses and methods, and in particular, to an electrical activity sensor in which an exemplary impulse acquisition circuitry detects and determines a nature of transitional impulse response emerging on a power cable.

### Background Information

This section is intended to introduce a reader to various aspects of art, which may be related to various aspects of the present principles that are described and/or claimed below. This discussion is believed to be helpful in providing the reader with background information to facilitate a better understanding. Accordingly, it should be understood that these statements are to be read in this light, and not as admissions of prior art.

The above-mentioned published International (PCT) Patent Application WO 2014/173783 A1 discloses an electrical activity monitoring system, including on an electrical activity sensor unit (also known as an RFID sensor or an RFID tag), attachable to a power cable of an electrical device for monitoring the electrical status of the electrical device. The sensor unit has an antenna and wirelessly communicates with an RFID reader of the system via the antenna. The antenna has dual functions: (1) to provide an electro-magnetic coupling for a transitional impulse response generated on the power cable in response to a change of electrical power state of the electrical device and (2) to wirelessly transmit data to the RFID reader.

The above-mentioned published U.S. Patent Application US 2015/0294127 A1 discloses an antenna structure suitable for the electrical activity sensor unit. The antenna has at least one dipole-type element configured to operate as a half-wave dipole in an operating range of frequencies for wireless communication with the RFID reader. The dipole-type element is configured to perform the foregoing dual functions.

The above-mentioned European Patent Application No. 15305815.1 discloses an antenna structure suitable for the electrical activity sensor unit. The antenna has at least a plurality of loop elements for electro-magnetic coupling to the power cable.

In order for an electrical activity sensor unit to detect and to determine a change of the power state properly, at least two kinds of changes (i.e., two different natures of the impulse responses) are accurately distinguished (i.e., from a power-ON state to a power-OFF state; from a power-OFF state to a power-ON state). A problem may arise if the impulse acquisition circuitry of the sensor unit, including an impulse detector, fails to distinguish these two kinds of changes from the impulse responses received.

### SUMMARY OF THE INVENTION

Accordingly, the present principles provide an apparatus. The apparatus includes an impulse detector and a microcontroller. The microcontroller is coupled in signal communication to the impulse detector. The impulse detector is operative to receive an impulse response from an antenna. The impulse detector is operative to provide one of a single alert signal and a plurality of alert signals for the microcontroller in response to the impulse response. The impulse response includes one of a single impulse waveform and a plurality of impulse waveforms in a time period. The impulse detector generates the single alert signal when the impulse response includes the single impulse waveform. The impulse detector generates the plurality of alert signals when the impulse response includes respective ones of the plurality of impulse waveforms. The microcontroller is operative to determine a nature of the impulse response. The nature is determined as a switch-ON response when the single alert signal is received. The nature is determined as a switch-OFF response when the plurality of alert signals are received.

Accordingly, the present principles further provide an apparatus. The apparatus includes an impulse detector and a microcontroller. The microcontroller is coupled in signal communication to the impulse detector. The impulse detector is operative to receive an impulse response from an antenna. The impulse detector is operative to provide one of a single alert signal and a plurality of alert signals for the microcontroller in response to the impulse response. The impulse response includes one of a single impulse waveform and a plurality of impulse waveforms in a time period. The impulse detector generates the single alert signal when the impulse response includes the single impulse waveform. The impulse detector generates the plurality of alert signals when the impulse response includes respective ones of the plurality of impulse waveforms. The microcontroller is operative to determine a nature of the impulse response. The nature is determined as a switch-ON response when the single alert signal is received. The nature is determined as a switch-OFF response when the plurality of alert signals are received.

The impulse detector includes a circuit and an analog-to-digital converter. The circuit has a first input point operative to receive the impulse response from the antenna. The analog-to-digital converter has a second input point. The circuit is coupled between the first input point and the second input point. The circuit includes a first capacitor, a second capacitor, a first diode, a second diode, and a resister. The second capacitor and the second diode coupled in series are coupled between the first input point and the second input point. The first diode is coupled between a first node and a point of reference potential. The first node is between said second capacitor and the second diode. The first capacitor is coupled between a second node and the point of reference potential. The second node is between the second diode and the second input point. The resistor is coupled between the second node and the point of reference potential.

A first value of the first capacitor is substantially identical to a second value of the second capacitor. The first capacitor and the resistor provide a time constant in order for the analog-to-digital converter to respond to at least one of the switch-ON impulse response and the switch-OFF impulse response distinctively.

The present principles provide a method. The method includes receiving an alert indication from an impulse detector, the alert indication including one of a single alert signal and a plurality of alert signals in a time period; analyzing a nature of the alert indication; first determining the nature as a switch-ON alert indication if a single alert signal is received in the time period; second determining the nature as a switch-OFF alert indication if a plurality of alert signals are received in the time period; and transmitting a result of one of the first and second determining steps to an RFID chip via a signal bus.

The present principles further provide a method. The method includes receiving an alert indication from an impulse detector, the alert indication including one of a single alert signal and a plurality of alert signals in a time period; analyzing a nature of the alert indication; first determining the nature as a switch-ON alert indication if a single alert signal is received in the time period; second determining the nature as a switch-OFF alert indication if a plurality of alert signals are received in the time period; and transmitting the determined nature (i.e., either the switch-ON alert indication or the switch-OFF alert indication) to an RFID chip via a signal bus. The analyzing step includes counting a number of alert signals in the time period.

The present principles further provide an apparatus. The apparatus includes first means, such as an impulse detector, for detecting an impulse response and second means, such as a microcontroller, coupled in signal communication to the first means for controlling the first means. The first means receives the impulse response from an antenna. The first means provides one of an alert signal and a plurality of alert signals for the second means in response to the impulse response. The impulse response includes one of a single impulse waveform and a plurality of impulse waveforms in a time period. The first means generates the single alert signal when the impulse response includes the single impulse waveform. The first means generates the plurality of alert signals when the impulse response includes respective ones of the plurality of impulse waveforms. The second means determines a nature of the impulse response. The nature is determined as a switch-ON response when the single alert signal is received. The nature is determined as a switch-OFF response when the plurality of alert signals are received.

The present principles further provide an apparatus. The apparatus includes first means, such as an impulse detector, for detecting an impulse response and second means, such as a microcontroller, coupled in signal communication to the first means for controlling the first means. The first means receives the impulse response from an antenna. The first means provides one of an alert signal and a plurality of alert signals for the second means in response to the impulse response. The impulse response includes one of a single impulse waveform and a plurality of impulse waveforms in a time period. The first means generates the single alert signal when the impulse response includes the single impulse waveform. The first means generates the plurality of alert signals when the impulse response includes respective ones of the plurality of impulse waveforms. The second means determines a nature of the impulse response. The nature is determined as a switch-ON response when the single alert signal is received. The nature is determined as a switch-OFF response when the plurality of alert signals are received.

The first means includes third means, such as a circuit. The third means has a first input point for receiving the impulse response from the antenna. The first means further includes fourth means, such as an analog-to-digital converter, for generating said one of said alert signal and said plurality of alert signals. The fourth means has a second input point. The third means is coupled between the first input point and the second input point. The third means includes a first capacitor, a second capacitor, a first diode, a second diode, and a resister. The second capacitor and the second diode coupled in series are coupled between the first input point and the second input point. The first diode is coupled between a first node and a point of reference potential. The first node is positioned between the second capacitor and said second diode. The first capacitor is coupled between a second node and the point of reference potential. The second node is positioned between the second diode and the second input point. The resistor is coupled between the second node and the point of reference potential. A first value of the first capacitor is substantially identical to a second value of the second capacitor. The first capacitor and the resistor provide a time constant in order for the fourth means to respond to at least one of the switch-ON impulse response and the switch-OFF impulse response distinctively.

### BRIEF DESCRIPTION OF THE DRAWINGS

The features and advantages of the present principles may be apparent from the detailed description below when taken in conjunction with the figures described below. In the drawings, the same reference numerals denote similar elements throughout the views, wherein:
Fig. 1 illustrates an exemplary electrical activity monitoring system, in which one or more embodiments of the present principles may be implemented, according to the present principles;
Fig. 2 illustrates, in a form of functional block diagram, an exemplary electrical activity sector unit including impulse acquisition circuitry and an antenna assembly according to the present principles;
Fig. 3 illustrates exemplary wiring connections between the impulse acquisition circuitry and the antenna assembly according to the preset principles;
Fig. 4 shows exemplary physical dimensions of the antenna assembly according to the present principles;
Fig. 5 illustrates an enlarged view of a wiring connection area between the loop antenna element and the printed circuit board (PCB) on which the impulse acquisition circuitry resides according to the present principles;
Fig. 6 illustrates an effect of the inductance elements on the impedance (real part) of the FLEX antenna, based upon a computer simulation, according to the present principles;
Fig. 7 illustrates an effect of the inductance elements on the impedance (imaginary part) of the FLEX antenna, based upon a computer simulation, according to the present principles;
Fig. 8 illustrates an impedance response (real part) of the FLEX antenna against a physical length of the impulse signal path, based upon a computer simulation, according to the present principles;
Fig. 9 illustrates an impedance response (imaginary part) of the FLEX antenna against a physical length of the impulse signal path, based upon a computer simulation, according to the present principles;
Fig. 10 illustrates an impedance response (real part) of the FLEX antenna against RF frequencies (840 MHz - 990 MHz), based upon a computer simulation, according to the present principles;
Fig. 11 illustrates an impedance response (imaginary part) of the FLEX antenna against RF frequencies (840 MHz - 990 MHz), based upon a computer simulation, according to the present principles;
Fig. 12 illustrates a three-dimensional (3D) radiation pattern of the FLEX antenna, based upon a computer simulation, according to the present principals;
Fig. 13 illustrates a radiation pattern of the FLEX antenna with respect to the two-orthogonal planes (i.e., the E and H planes), based upon a computer simulation, according to the present principals;
Fig. 14 illustrates an overall physical view of the antenna assembly, according to the present principles;
Fig. 15 illustrates an exemplary embodiment of the FLEX antenna, in which an RF coupling between the dipole-type antenna element and the loop antenna element is provided in the vicinity of an edge of the dipole-type antenna element according to the present principles;
Fig. 16 illustrates another exemplary embodiment of the FLEX antenna, in which an RF coupling between the dipole-type antenna element and the loop antenna element is provided in the vicinity of the center of the dipole-type antenna element according to the present principles;
Fig. 17 illustrates two switch-ON impulse responses captured by the FLEX antenna at respective ones of two measurement points on the same power cable according to the present principles;
Fig. 18 illustrates two switch-OFF impulse responses captured by the FLEX antenna at respective ones of two measurement points on the same power cable according to the present principles;
Fig. 19 illustrates an overall measurement scene for capturing the impulse responses shown in Figs. 17 and 18, according to the present principles;
Fig. 20 illustrates an erroneous operation of an analog-to-digital converter, which is part of the impulse detector, based upon an experiment;
Fig. 21 illustrates a proper operation of the analog-to-digital converter, which is part of the impulse detector, based upon an experiment, according to the present principles;
Fig. 22 describes an exemplary impulse detector in a form of schematic diagram according to the present principles;
Fig. 23 illustrates an operation of the preconditioning circuit, based on a computer simulation, according to the present principles;
Fig. 24 illustrates an enlarged view of an area in the vicinity of the impulse waveform shown in Fig. 23, based upon a computer simulation, according to the present principles;
Fig. 25 illustrates an exemplary overall operation of the impulse detector, based on a measurement, according to the present principles;
Fig. 26 illustrates an exemplary overall operation of the electrical activity sensor unit, in a form of functional block diagram, according to the present principles;
Fig. 27 illustrates, in a form of flow chart, an exemplary process operative to determine a nature of the alert indication generated by the impulse detector according to the present principles;
Fig. 28 illustrates, in a form of flow chart, an exemplary process operative to determine a nature of the alert indication generated by the impulse detector, which process includes an additional step to the process disclosed in Fig. 27, according to the present principles;
Fig. 29 illustrates an exemplary implementation of part of the process disclosed in Fig. 27, in a form of flowchart, according to the present principles; and
Fig. 30 illustrates an exemplary implementation of the process disclosed in Fig. 28, in a form of flowchart, according to the present principles.

The examples set out herein illustrate exemplary embodiments of the present principles. Such examples are not to be construed as limiting the scope of the present principles in any manner.

### DETAILED DESCRIPTION

The present description illustrates the present principles. It will thus be appreciated that those skilled in the art will be able to devise various arrangements that, although not explicitly described or shown herein, embody the present principles and are included within its scope.

All examples and conditional language recited herein are intended for pedagogical purposes to aid the reader in understanding the present principles and the concepts contributed by the inventors to furthering the art, and are to be construed as being without limitation to such specifically recited examples and conditions.

Moreover, all statements herein reciting principles, aspects, and embodiments of the present principles, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

Thus, for example, it will be appreciated by those skilled in the art that the block diagrams presented herein represent conceptual views of illustrative circuitry embodying the present principles. Similarly, it will be appreciated that any flow charts, flow diagrams, state transition diagrams, pseudocode, and the like represent various processes which may be substantially represented in computer readable media and so executed by a computer or processor, whether or not such computer or processor is explicitly shown.

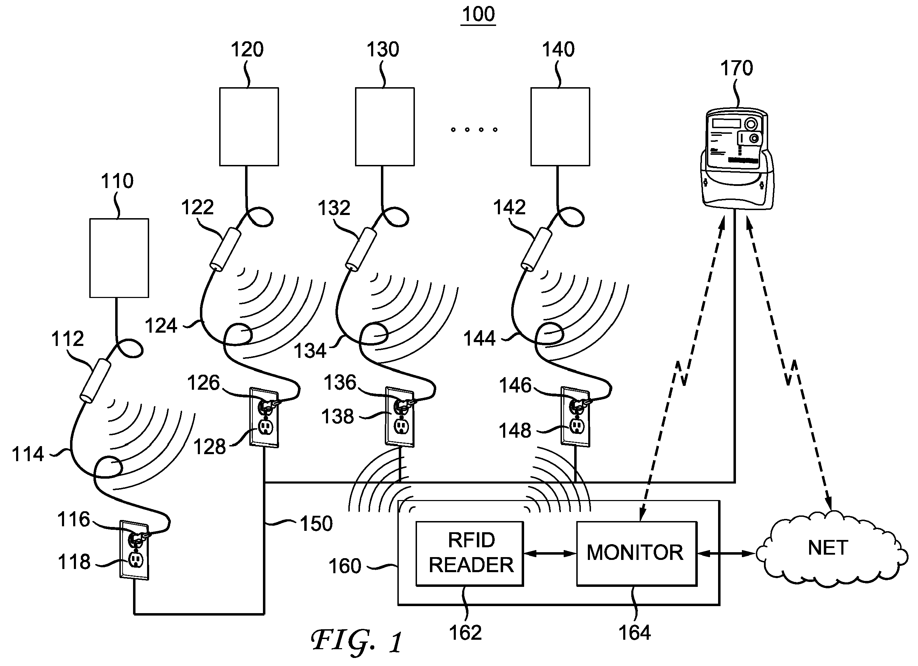

The functions of the various elements disclosed the accompanying functional diagrams and/or flow charts (such as Figs. 1, 2, 3, 22, 26, 27, 28, 29, and 30) may be provided through the use of dedicated hardware and/or hardware capable of executing software in association with appropriate software. When provided by a processor, the functions described herewith may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include implementations such as, without limitation, digital signal processor ("DSP") hardware, Programmable Logic Array (PLA), Application Specific Integrated Circuit (ASIC), read-only memory ("ROM") for storing software, random access memory ("RAM"), non-volatile storage, or the like.

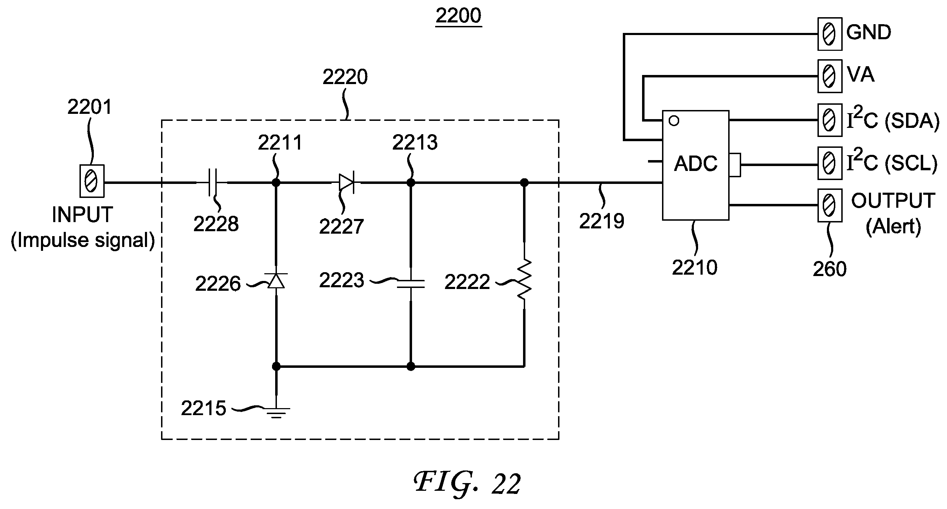

Also, although each of the components in the drawings is shown as an individual block, each individual block may further represent, e.g., one or more combinations of circuitries such as, e.g., one or more integrated circuits (ICs), one or more circuit boards, or one integrated circuit (IC) with one or more circuitries embedded on the same IC die, as well known in the art. For example, a circuit disclosed in Fig. 22 may represent one or more integrated circuits or circuit boards having a combination of different functional capabilities such as, e.g., ADC, filter, etc. as to be described in more detail below.

In the claims hereof, any element expressed as a means for performing a specified function is intended to encompass any way of performing that function including, for example, (1) a combination of circuit elements that performs that function or (2) software in any form, including, therefore, firmware, microcode or the like, combined with appropriate circuitry for executing that software to perform the function. The present principles as defined by such claims reside in the fact that the functionalities provided by the various recited means are combined and brought together in the manner which the claims call for. It is thus regarded that any means that can provide those functionalities are equivalent to those shown herein.

Reference in the specification to "one embodiment", "an embodiment", "an exemplary embodiment" of the present principles, or as well as other variations thereof, means that a particular feature, structure, characteristic, and so forth described in connection with the embodiment is included in at least one embodiment of the present principles. Thus, the appearances of the phrase "in one embodiment", "in an embodiment", "in an exemplary embodiment", or as well any other variations, appearing in various places throughout the specification are not necessarily all referring to the same embodiment.

It is to be appreciated that the use of any of the following "/", "and/or", and "at least one of', for example, in the cases of "A/B", "A and/or B" and "at least one of A and B", is intended to encompass the selection of the first listed option (A) only, or the selection of the second listed option (B) only, or the selection of both options (A and B). As a further example, in the cases of "A, B, and/or C" and "at least one of A, B, and C", such phrasing is intended to encompass the selection of the first listed option (A) only, or the selection of the second listed option (B) only, or the selection of the third listed option (C) only, or the selection of the first and the second listed options (A and B) only, or the selection of the first and third listed options (A and C) only, or the selection of the second and third listed options (B and C) only, or the selection of all three options (A and B and C). This may be extended, as readily apparent by one of ordinary skill in this and related arts, for as many items listed.

Fig. 1 illustrates exemplary electrical activity monitoring system 100, in which one or more embodiments of the present principles may be implemented. Monitoring system 100 monitors changes in electrical states with respect to each one of a plurality of electrical devices 110, 120, 130, and 140. For example, such electrical devices may include an air conditioner, a heating system, or large household appliances, such as a refrigerator, a cooker, a washing machine, etc. The plurality of electrical devices 110, 120, 130, and 140 are connected to respective ones of a plurality of power outlets 118, 128, 138, and 148. Such connections of a plurality of electrical devices 110, 120, 130, and 140 to the power outlets are made via respective ones of a plurality of power cables 114, 124, 134, and 144.

It will be appreciated that while as illustrated in Fig. 1 a plurality of electrical devices 110, 120, 130, and 140 may be connected to respective ones of a plurality of power outlets 118, 128, 138, and 148 individually, in another embodiment, such a plurality of electrical devices may be connected to a common single power outlet.

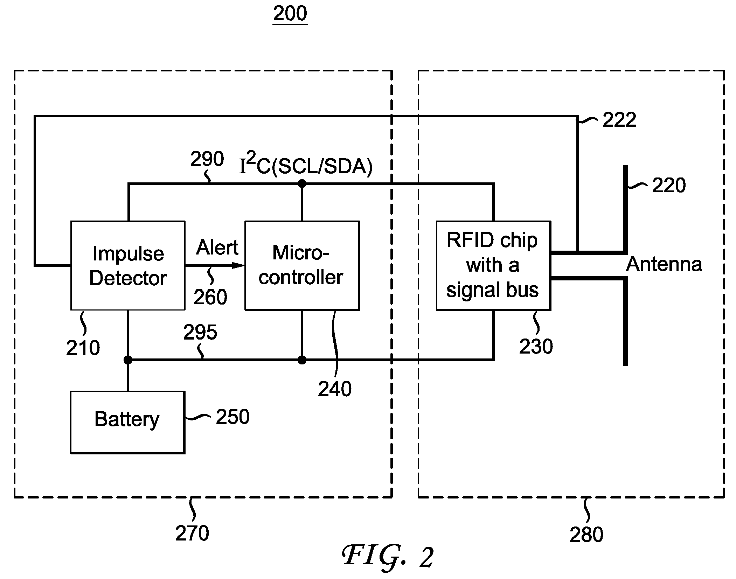

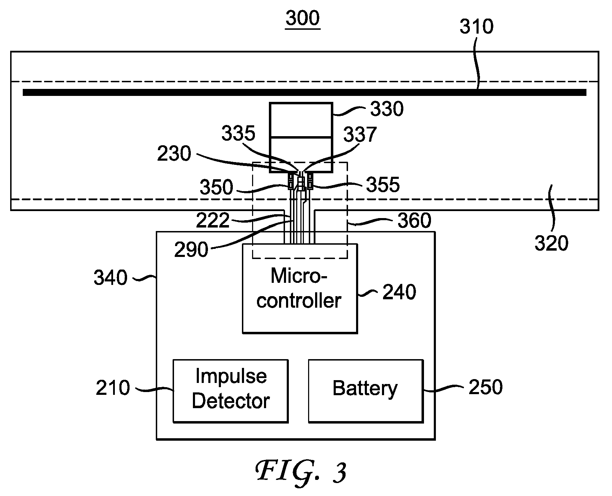

A plurality of electrical power cables 114, 124, 134, and 144 have respective ones of a plurality of plugs 116, 126, 136, and 146. The plurality of plugs 116, 126, 136, and 146 are provided for connecting to power supply network 110 via respective ones of a plurality of power outlets 118, 128, 138, and 148. A plurality of electrical activity sensor units (also known as "RFID tags") 112, 122, 132, and 143 are wrapped around respective ones of a plurality of electrical power cable 114, 124, 134, and 144 for establishing electro-magnetic couplings for capturing the impulse responses. Each one of a plurality of electrical activity sensor units 112, 122, 132, and 143 includes flexible substrate (FLEX) antenna assembly 280 and impulse acquisition circuitry 270 on a printed circuit board (PCB) 340 as shown in Figs. 2 and 3.

Electrical activity monitoring system 100 further includes electrical activity monitoring apparatus 160 and power supply network 150. Power supply network 150 typically includes electricity meter 170 for measuring power consumption in the power supply network 150. Electrical activity monitoring apparatus 170 may be connected to a communication network NET, such as the Internet, so that the data representing the activities of the electrical devices may be transmitted to a remote device (not shown), such as an electrical activity monitoring device remotely located at a power company.

Fig. 2 illustrates, in a form of functional block diagram, an exemplary electrical activity sensor unit 200, such as one of sensor units 112, 124, 134, 144 in Fig. 1. Sensor unit 200 includes impulse acquisition circuitry 270 and antenna assembly 280.

Impulse acquisition circuity 270 is located on a printed circuit board (PCB) 340 as shown in Fig. 3 and includes impulse detector 210, micro-controller 240, and battery 250. FLEX antenna assembly 280 is developed on a flexible dielectric substrate and includes RFID chip 230 and FLEX antenna 220. Impulse acquisition circuitry 270 and FLEX antenna assembly 280 are connected via signal path 222 for impulse responses and via signal communication bus 290, such as I²C bus, for data/control signals.

More specifically, RFID chip 230 has a wireless connection with RFID reader 162 via antenna 220 as shown in Fig. 1. Furthermore, RFID chip 230 has a wired communication with both impulse detector 210 and microcontroller 240 via signal communication bus 290. For example, SL3S4011, SL2S4021 available from NXP™ Semiconductors or Monza X available from IMPINJ™ may be used as RFID chip 230. In addition, for example, PIC 16LF1823 (QFN package) available from Microchip™ or MSP430F1x available from Texas Instruments™ may be used as micro-controller 240.

Here, a typical operation of electrical activity sensor unit 200 is described. When a power state of electrical device, such as one of device 110, 120, 130, and 140 shown in Fig. 1, changes (e.g., from a power-ON state to a power-OFF state or vice versa), a transitional impulse response emerges on the power cable through which the operating power for the device is provided. Antenna 220, which is electro-magnetically coupled to the power cable, captures such an impulse response. The captured impulse response is provided to Impulse detector 210 via impulse signal path 222.

Upon receipt of the impulse response, impulse detector 210 generates alert indication 260. Alert indication 260 is then provided to microcontroller 240 via signal communication bus 290 such as I²C bus. Alternatively, alert indication 260 may be provided to microcontroller 240 via a separate signal path other than signal communication bus 290. Microcontroller 240 determines a nature of the impulse response. More specifically, microcontroller 240 determines whether such impulse response may be generated as a result of a switch-ON operation (i.e., from a switch-OFF state to a switch-ON state) or as a result of switch-OFF operation (i.e., from a switch-ON state to a switch-OFF state). Such a determination is made by analyzing a waveform pattern of the impulse response. A software program for analyzing the waveform pattern resides in a memory (not shown) for microcontroller 240.

When the captured impulse at antenna 220 is determined by microcontroller 240 as an indication of a change of power state of the electrical device, such information on the change of the power state is communicated to RFID chip 230 via signal communication bus 290. The power state-change information is stored in a memory (not shown) associated with RFID chip 230. Then RFID chip 230 relays such state-change information wirelessly to RFID reader 162 shown in Fig. 1, for example, on a UHF band of frequencies via antenna 220. Battery 250 provides an operating power for impulse detector 210, microcontroller 240, and RFID chip 230 via operating power path 295.

Fig. 3 illustrates exemplary wiring connections between impulse acquisition circuitry 270 and antenna assembly 280. More specifically, FLEX antenna assembly 280 is connected in signal communication to impulse acquisition circuitry 270 located on Printed Circuit Board (PCB) 340. FLEX antenna assembly 280 includes FLEX antenna 220, which includes at least two antenna elements. One is dipole-type antenna element 310, and the other is a loop antenna element 330. In this embodiment, dipole-type antenna element 310 is designed to be tuned to an operating frequency of the RFID system in a UHF band of frequencies (e.g., 915MHz in the U.S.; 866MHz in Europe).

Loop antenna element 330 is RF coupled to dipole-type antenna element 310 and provides an RF signal connection between FLEX antenna 220 and each one of RFID chip 230 and impulse detector 210. In particular, loop antenna element 330 exhibits at least two functions: (1) to provide a proper impedance matching between FLEX antenna 220 and RFID chip 230 and (2) to provide an optimal impulse coupling between impulse detector 210 and the power cable.

Both antenna elements 310 and 330 may, for example, be etched on flexible substrate 320 of FLEX antenna assembly 280. Substrate 320 may, for example, be made of a thin Polystyrene adhesive film in such a way that FLEX antenna assembly 280 may be flexible enough to be physically wrapped around the power cable. That is, an electro-magnetic coupling between FLEX antenna 220 and the power cable may be obtained for the impulse responses. FLEX antenna assembly 280 further includes RFID chip 230 and two inductance elements 350, 355. Printed circuit board (PCB) 340 includes micro-controller 240, impulse detector 210, and battery 250. RFID chip 230 on FLEX antenna assembly 280 and micro-controller 240 on PCB 340 are coupled in signal communication via a wired signal communication bus 290, such as an I²C bus.

RFID chip 230 has at least two connection points for respective ones of two signals. One connection point is for RF signals in a band of UHF frequencies, and the other connection point is for a signal communication bus, such as I²C bus. RFID chip 230 is located in the vicinity of feed points 335, 337 of loop antenna element 330 on antenna assembly 280. The signal and ground terminals of the RF connection point are coupled in RF signal communication to respective ones of feed points 335, 337.

Two feed points 335, 337 of loop antenna element 330 are coupled in signal communication to impulse detector 210 on PCB 340 via respective ones of inductance elements 350 and 355. Inductance elements 350, 355 operate to isolate the RF signals, in a band of UHF frequencies, generated by RFID chip 230 from impulse acquisition circuitry 270. Such isolation prevents the RF signals generated by RFID chip 230 from negatively effecting an operation of impulse acquisition circuity 270.

Inductance elements 350, 355 may have the same inductance value and are located in the vicinity of respective ones of feed points 335 and 337. In this embodiment, an exemplary inductance value for each one of inductance elements 350, 355 is determined to be one hundred nanohenries (100 nH). This inductance value is provided only as an example and should not be used to limit the scope of the present principles.

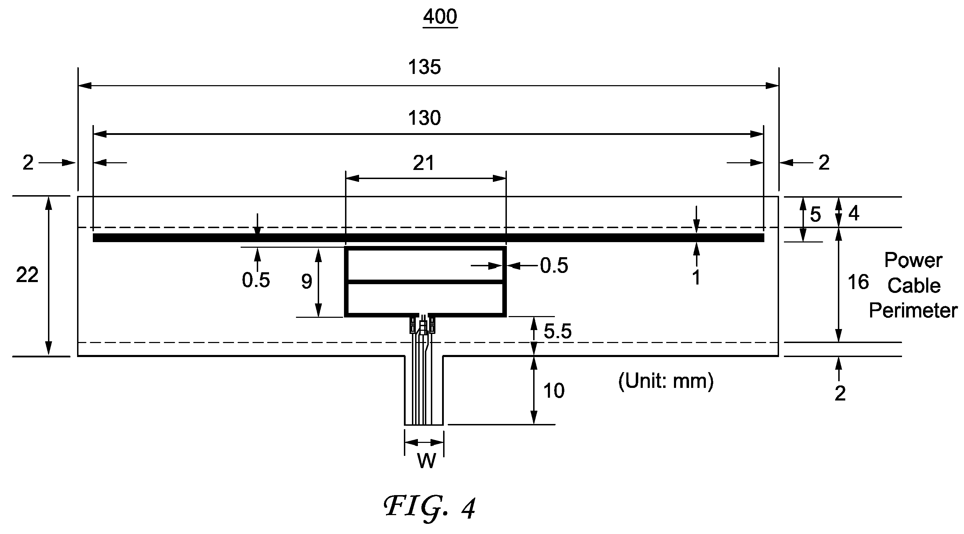

Fig. 4 shows exemplary physical dimensions of antenna assembly 280. Needless to say, different dimensions may be determined as optimal dimensions, depending upon a specific implementation of the present principles. The specific physical dimensions provided herein are disclosed solely for the purpose of examples and should not be used to limit the scope of the present principles.

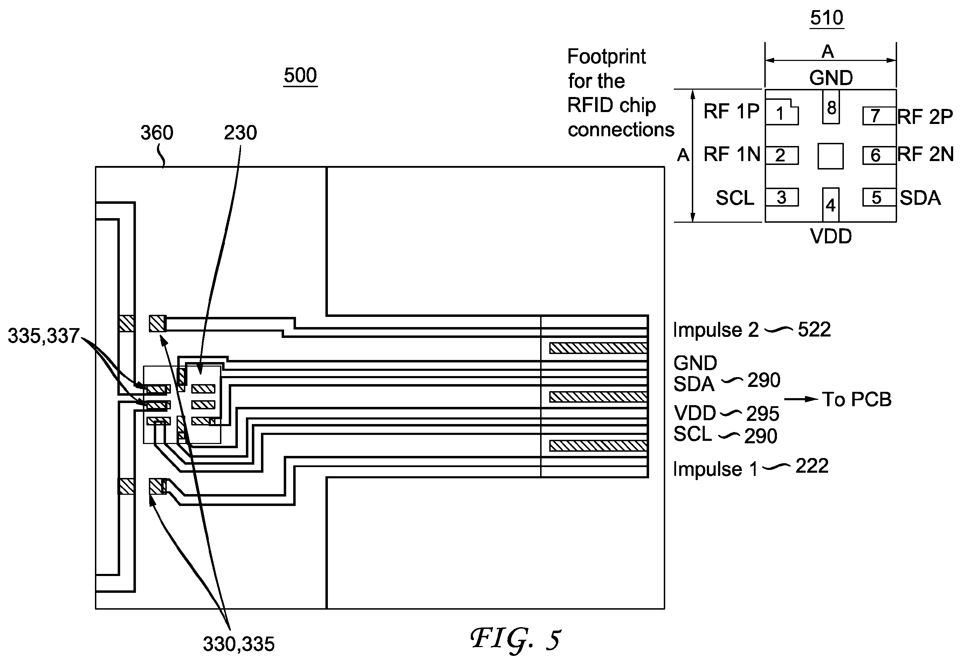

Fig. 5 illustrates enlarged view 500 of wiring connection area 360 between loop antenna element 330 and printed circuit board (PCB) 340, as shown in Fig. 3, on which impulse acquisition circuitry 270 resides. Wiring connection area 360 includes impulse signal path 222 for impulse responses, signal communication bus 290 for data/control signals, and operating power path 295 for providing an operating power for RFID chip 230 from battery 250. RF ground path 522 provides an RF ground for the impulse responses.

Impulse signal path 222 and RF ground path 522 provide a signal connection for the impulse responses between FLEX antenna 220 and impulse detector 210 via respective ones of inductance elements 350 and 355. Signal communication path 290 includes at least two independent signal lines for an I²C bus (i.e., SDA and SCL). Signal communication path 290 provides signal communications among RFID chip 230, impulse detector 210, and microcontroller 240. Operating power path 295 provides an operating power for RFID chip 230, which is located on FLEX antenna assembly 220, from battery 250, which is located on PCB 340. Pin configuration 510 of RFID chip 230 is shown as an example.

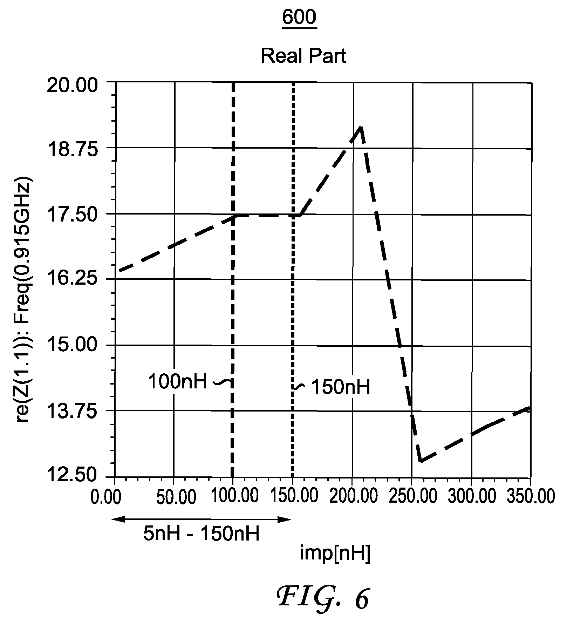

Fig. 6 illustrates an effect of inductance elements 350, 355 on the impedance (real part) of FLEX antenna 220, based upon a computer simulation. More specifically, Fig. 6 shows an impedance response of FLEX antenna 220 at the frequency of nine-hundred fifteen megahertz (915 MHz) in a range of inductance value between five nanohenries (5 nH) and three hundred fifty nanohenries (350 nH). As shown in Fig. 6, a common inductance value of five to one hundred fifty nanohenries (5 nH - 150 nH) for each one of inductance elements 350 and 355 exhibits relatively a uniform impedance response with respect to the real part of the impedance of FLEX antenna 220.

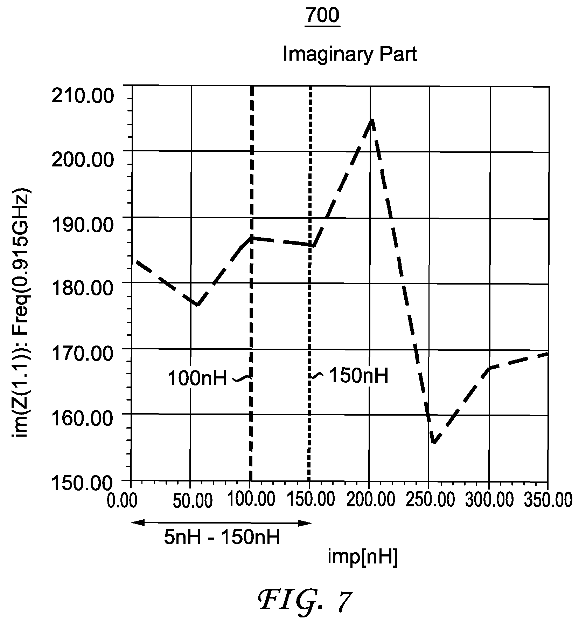

Fig. 7, similarly, illustrates an effect of inductance elements 350, 355 on the impedance (imaginary part) of FLEX antenna 220, based upon a computer simulation. More specifically, Fig. 7 shows an impedance response of FLEX antenna 220 at the frequency of nine-hundred fifteen megahertz (915 MHz) in a range of inductance value between five nanohenries (5 nH) and three hundred fifty nanohenries (350 nH). As shown in Fig. 7, a common inductance value above one hundred fifty nanohenries (150 nH) for each one of inductance elements 350 and 355 exhibits a significant level of variance with respect to the imaginary part of the impedance of FLEX antenna 220.

In consideration of the results provided by Figs. 6 and 7 described above, an exemplary value of one hundred nanohenries (100 nH) for each one of inductance elements 350 and 355 is determined with respect to this specific embodiment. Needless to say, a different inductance value may be determined as an optimal value, depending upon a specific implementation of the present principles. An exemplary value of one hundred nanohenries (100 nH) disclosed herein should not be used to limit the scope of the present principles. Here, the commercially-available simulation software HFSS™ provided by Ansoft Corporation is used to obtain the results shown in Figs. 6 and 7.

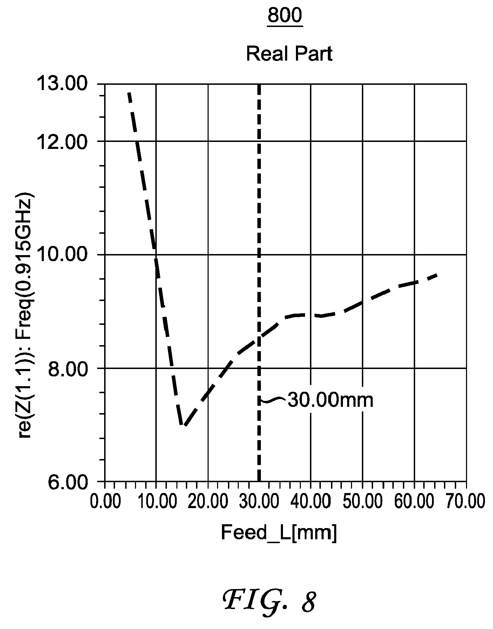

Fig. 8 illustrates an impedance response (real part) of FLEX antenna 220 against a physical length of impulse signal path 222, based upon a computer simulation. More specifically, Fig. 8 shows an impedance response (real part) of FLEX antenna 220 at the frequency of nine-hundred fifteen megahertz (915 MHz) in a length of impulse signal path 222 between five millimeters (5.00 mm) and sixty millimeters (60.00 mm).

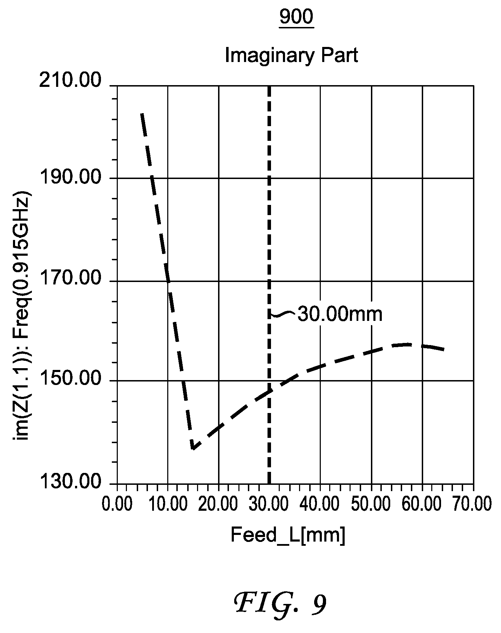

Fig. 9 similarly illustrates an impedance response (imaginary part) of FLEX antenna 220 against a physical length of impulse signal path 222, based upon a computer simulation. More specifically, Fig. 9 shows an impedance response (imaginary part) of FLEX antenna 220 at the frequency of nine-hundred fifteen megahertz (915 MHz) in a length of impulse signal path 222 between five millimeters (5.00 mm) and sixty millimeters (60.00 mm).

Figs. 8 and 9 show a relatively uniform impedance response of FLEX antenna 220 (typically 9 + j 157 ohm) above the length of thirty millimeters (30 mm), based upon a computer simulation. This indicates that the impedance of FLEX antenna 220 is substantially insensitive to a relatively large length of impulse signal path 222 (e.g., typically above thirty millimeters). In the computer simulation, the value of each one of the inductance elements 350, 355 is set at one hundred nanohenries (100 nH).

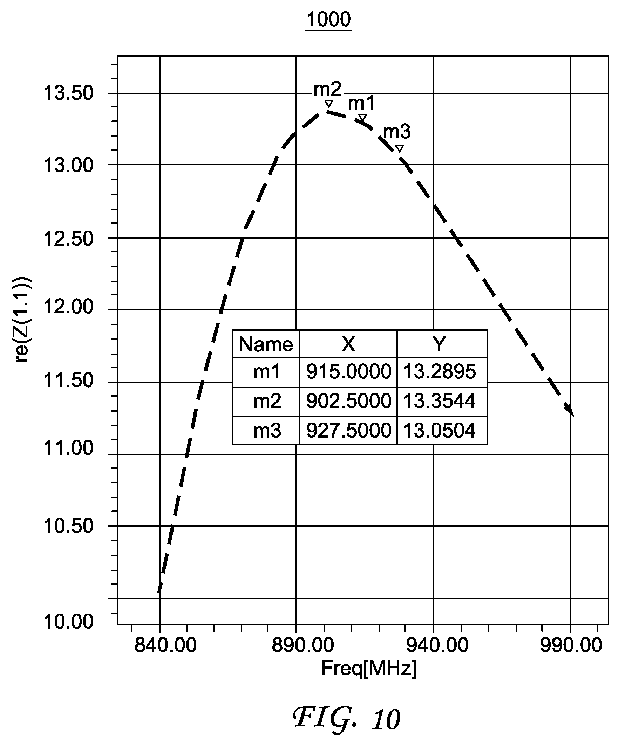

Fig. 10 illustrates an impedance response (real part) of FLEX antenna 220 against a band of RF frequencies (840 MHz - 990 MHz), based upon a computer simulation. The simulation includes an effect of inductance elements 350, 355-one hundred nano henries (100 nH) each.

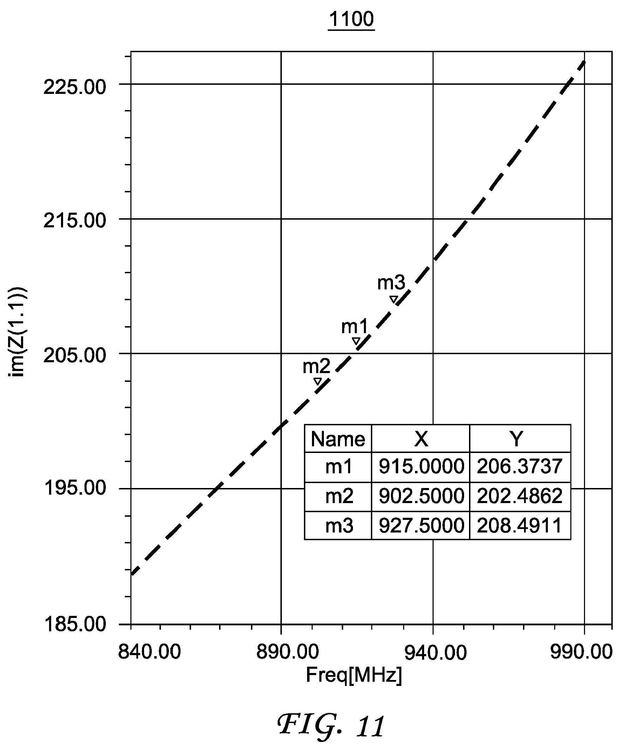

Fig. 11 similarly illustrates an impedance response (imaginary part) of FLEX antenna 220 against the same band of RF frequencies (840 MHz - 990 MHz), based upon a computer simulation. The simulation includes an effect of inductance elements 350, 355-one hundred nano henries (100 nH) each.

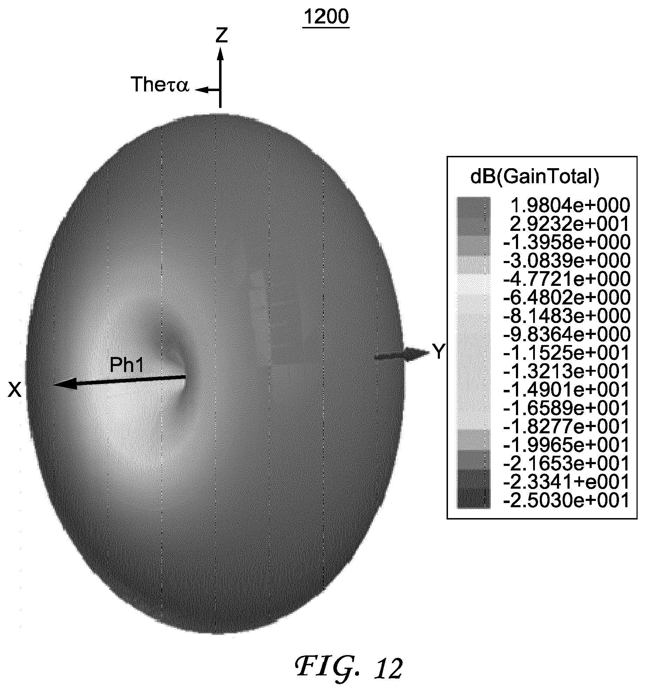

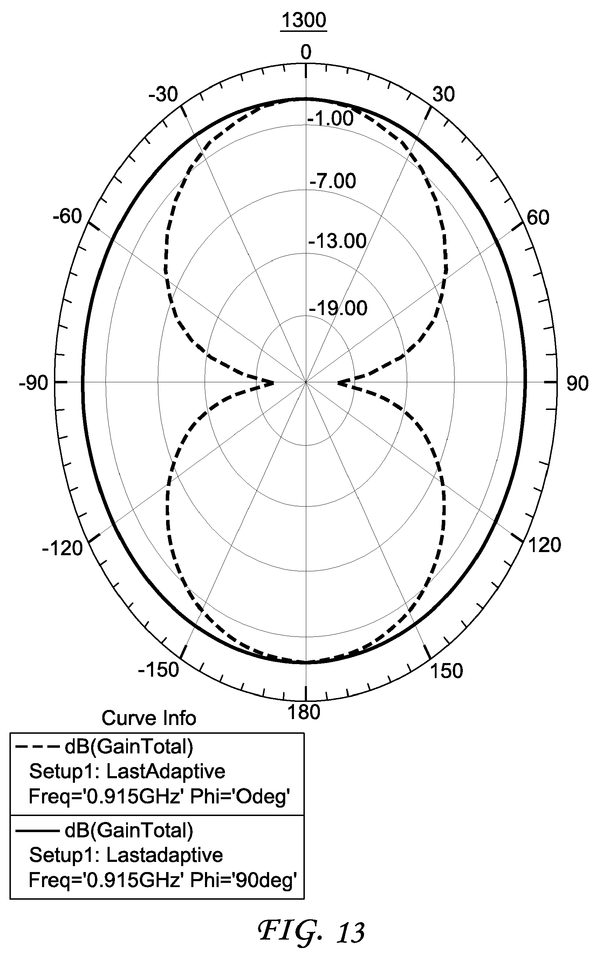

Figs. 12 and 13 show respective ones of two aspects 1200, 1300 of the radiation pattern of the FLEX antenna 220, based upon a computer simulation. More specifically, Fig. 12 illustrates a computer simulated 3D radiation pattern of FLEX antenna 220. Similarly, Fig. 13 illustrates a computer simulated radiation pattern of FLEX antenna 220 with respect to the two-orthogonal planes (i.e., the E and H planes). Figs. 12 and 13 show the radiation patterns similar to those of a classical dipole antenna.

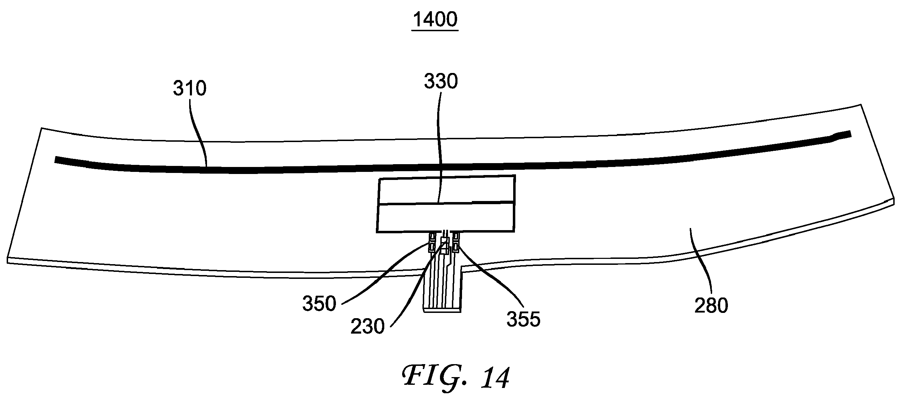

Fig. 14 illustrates an overall physical view 1400 of FLEX antenna assembly 280. FLEX antenna assembly 280 includes dipole-type antenna element 310, loop antenna element 330, RFID chip 230, and a pair of two inductance elements 350, 355 as described above.

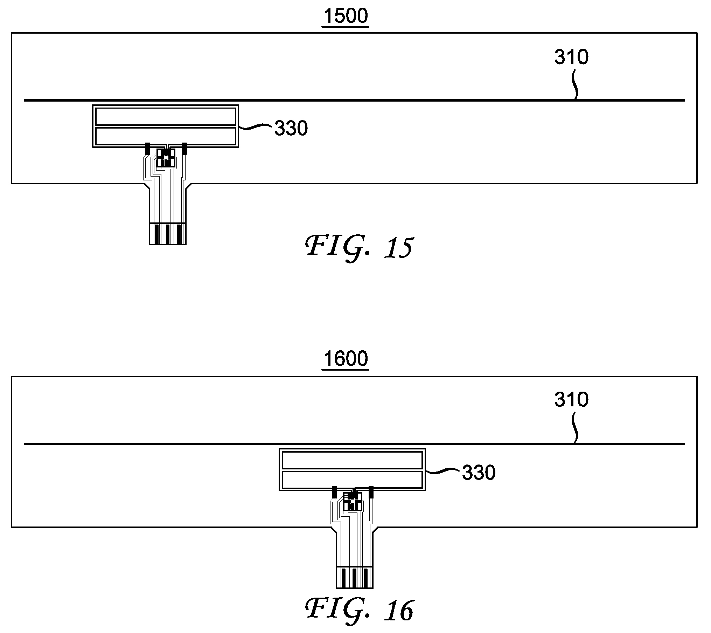

Fig. 15 illustrates an exemplary embodiment 1500 of FLEX antenna 220, in which the RF coupling between dipole-type antenna element 310 and loop antenna element 330 is provided in the vicinity of an edge of dipole-type antenna element 310. Fig. 16 illustrates another exemplary embodiment 1600 of FLEX antenna 220, in which the RF coupling between dipole-type antenna element 310 and loop antenna element 330 is provided in the vicinity of the center of dipole-type antenna element 310. The impedance of FLEX antenna 220 can be adjusted by changing a location of the RF coupling between dipole-type element 310 and loop antenna element 330.

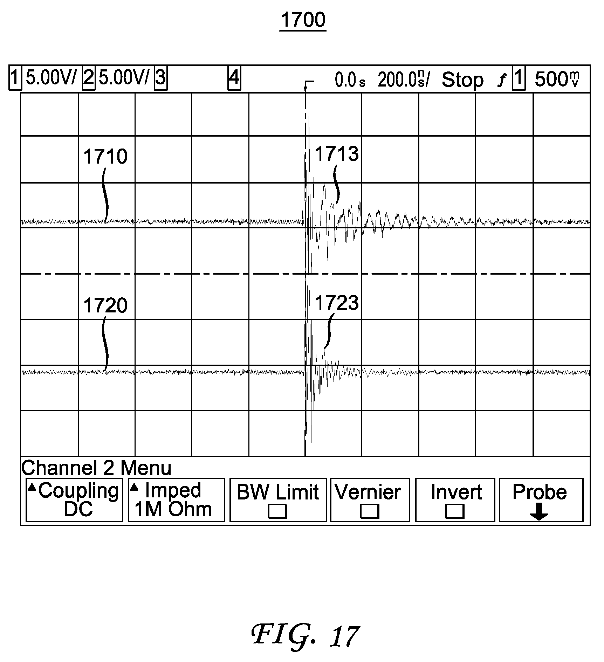

Fig. 17 illustrates two switch-ON impulse responses captured by FLEX antenna 220 at respective ones of two measurement points on a power cable. More specifically, two switch-ON impulse responses are measured at respective ones of two measurement points, separated approximately thirty centimeters (30 cm), on the same power cable. The power cable provides an operating power for an electrical device, of which power state changes from an OFF state to an ON state during the measurement.

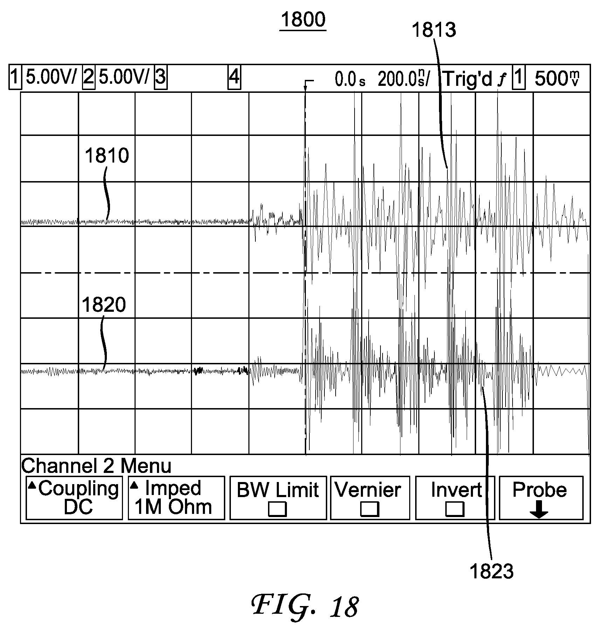

Fig. 18 illustrates two switch-OFF impulse responses captured by FLEX antenna 220 at respective ones of two measurement points on a power cable in a similar manner. More specifically, two switch-OFF impulse responses are measured at respective ones of two measurement points, separated approximately thirty centimeters (30 cm), on the same power cable. The power cable provides an operating power for the electrical device, of which power state changes from an ON state to an OFF state during the measurement.

As illustrated in Fig. 17, it has been discovered that a single impulse waveform emerges when a switch-ON impulse response is received, irrespective of the two different measurement points. On the other hand, as illustrated in Fig. 18, it has also been discovered that a series of a plurality of impulse waveforms emerge when a switch-OFF impulse response is received, irrespective of the two different measurement points. An overall appearance of each one of a plurality of impulse waveforms in a switch-OFF impulse response in Fig. 18 is similar to an overall appearance of a single impulse response in a switch-ON impulse response in Fig. 17.

More specifically, single impulse waveform 1713 emerges when switch-ON impulse response 1710 is captured at one measurement point. In the experiment for Fig. 17, switch-ON impulse waveform 1713 appears as a single damped quasi-sinusoidal waveform with a short quasi-period of less than thirty nanoseconds (30 ns). Switch-ON impulse waveform 1713 tends to be fading away towards zero (0) after less than twenty (20) quasi-periods-i.e., six-hundred nanoseconds (600 ns). The duration of switch-ON impulse waveform 1713 stays at a substantive level only for two hundred nanoseconds (200 ns). Similarly, single impulse waveform 1723 emerges when switch-ON impulse response 1720 is captured at another measurement point.

In contrast, a series of five impulse waveforms 1813 emerge when switch-OFF impulse response 1810 is captured at one measurement point. In the experiment for Fig. 18, a total duration of a series of five impulse waveforms 1813 exceeds rarely one hundred microseconds (100µs). Similarly, a series of five impulse waveforms 1823 emerge when switch-OFF impulse 1820 is captured at another measurement point.

In addition, an overall appearance of each one of a series of a plurality of impulse waveforms 1813 in switch-OFF impulse response 1810 appears to be similar to an overall appearance of single impulse waveform 1713 in switch-ON impulse response 1710. In the same manner, an overall appearance of each one of a series of a plurality of impulse waveforms 1823 in switch-OFF impulse response 1820 appears to be similar to an overall appearance of single impulse waveform 1723 in switch-ON impulse response 1720.

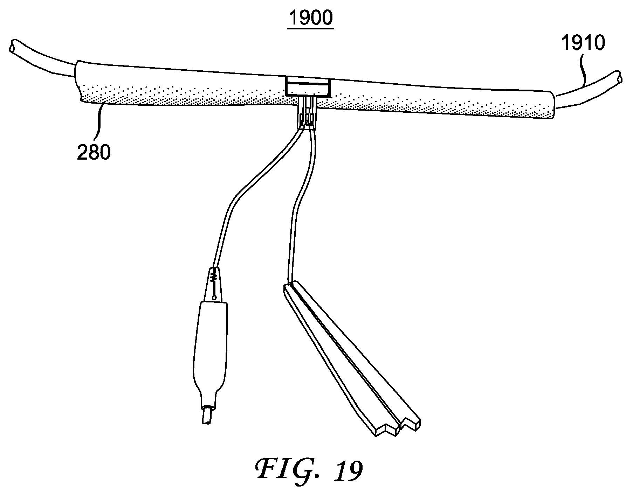

Fig. 19 represents an overall measurement scene 1900 for capturing impulse responses 1710, 1720, 1810, 1820 shown in Figs. 17 and 18. Here, FLEX antenna assembly 280 is wrapped around power cable 1910.

A nature of impulse response may be determined by analyzing distinctive patterns of impulse responses, as described above, in conjunction with Figs. 17 and 18. More specifically, a nature of particular impulse response may be determined as a switch-ON response when a single waveform is detected in the impulse response within a period. A nature of impulse response, on the other hand, may be determined as a switch-OFF response when a series of a plurality of impulse waveforms are detected in the impulse response within a period.

Impulse detector 210, such as the one shown in Fig. 2, properly operates to detect one of the distinctive patterns of impulse responses so that microcontroller 240 may be able to determine a nature of the response accurately. In other words, impulse detector 210 is designed to respond distinctively to a plurality of impulse responses having respective ones of the two different natures (i.e., a switch-ON response and a switch-OFF response). An erroneous determination of the nature of impulse response may occur when impulse detector 210, which includes an analog-to-digital converter (ADC), fails to response to a change(s) of impulse response in a timely manner.

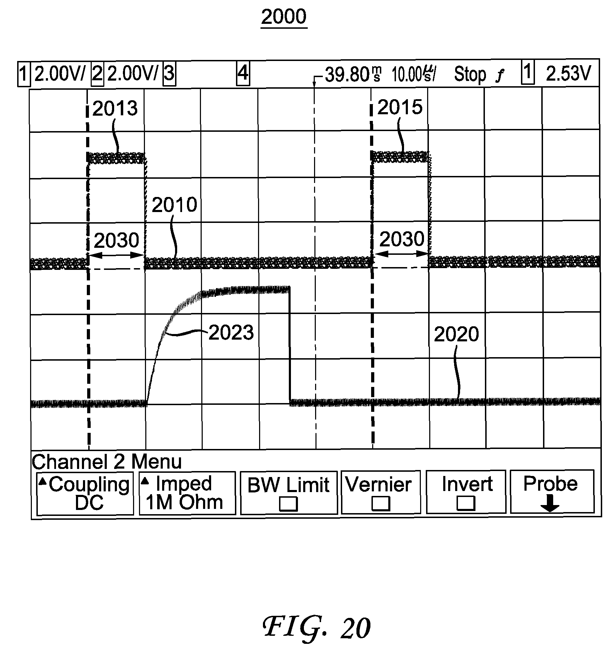

Fig. 20 illustrates an erroneous response 2000 of an analog-to-digital converter (ADC), which is to be included in impulse detector 210. An experiment has been conducted, using a signal generator generating a rectangular-period signal. In this experiment, the duty cycle of the rectangular-period signal is varied from twenty percent (20 %)-i.e., the pulse duration of ten microsecond (10 µs)-to seventy percent (70 %)-i.e., the pulse duration of thirty-five microsecond (35 µs)-for testing purposes. Here, the ADC081C021 available from Texas Instruments™ is used as an ADC.

More specifically, upper signal 2010 includes a series of rectangular-period signals 2013, 2015. Lower signal 2020 represents an output response of the ADC. The ADC responds to rectangular-period signal 2013 by generating output waveform 2023. That is, rectangular-period signal 2013 is properly detected by the ADC. In contrast, the ADC fails to detect rectangular-period signal 2015. That is, no output waveform is generated by the ADC in response to rectangular-period signal 2015. The experiment demonstrates that the operation of ADC becomes unstable at a given duration time 2030 of ten microseconds (10 µs).

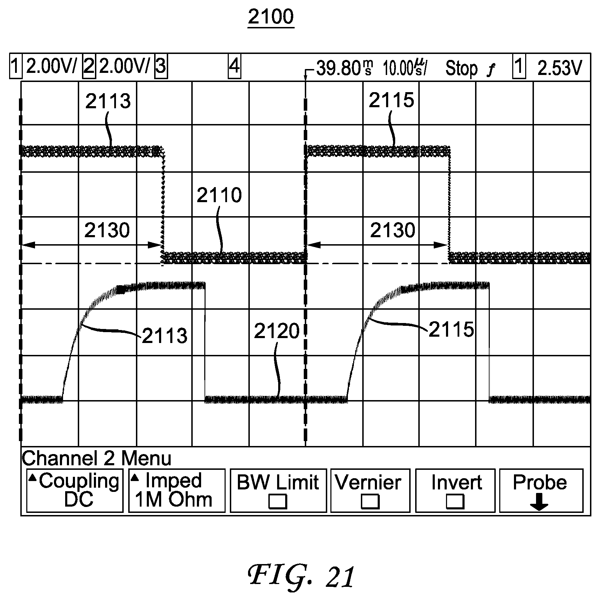

Fig. 21 illustrates similarly a proper response 2100 of the analog-to-digital converter (ADC), which is to be included in impulse detector 210. A similar experiment has been conducted. Here, upper signal 2110 includes a series of rectangular-period signals 2113, 2115. Lower signal 2120 represents output response 2120 of the ADC. The ADC responds to a series of rectangular-period signals 2113, 2115 by generating respective ones of output waveforms 2123, 2125. That is, each one of rectangular-period waveforms 20113 and 2115 is properly detected by the ADC. The experiment demonstrates that the ADC operates stably at a given duration time 2130 of twenty-five microseconds (25 µs).

The foregoing experiments reveal that the ADC tends to fail to respond accurately to a plurality of rectangular-period signals when each one of the rectangular-period signals does not have a sufficient time of duration. That is, in impulse detector 210, an insufficient duration time of an input signal to ADC 2210 in Fig. 22 would increase a risk of an erroneous determination of a change of the power state. The risk would be more apparent when a switch-ON impulse response is received. This is because a switch-ON impulse response includes only a single impulse waveform as described above. If impulse detector 210, including ADC 2210, fails to detect such a single impulse waveform, no change of the power state would be acknowledged.

In addition, a false detection of a power state of the electrical device may be caused by other reasons. For example, impulse detector 210 might erroneously detect various kinds of noise signals residing on the power cable as an impulse response. This is called as a "false positive" problem. For example, impulse detector 220 might erroneously detect a noise signal as a switch-ON response when the electrical device in fact is not turned ON. Similarly, impulse detector 220 might erroneously detect noise signals as a switch-OFF response when the electrical device in fact is not turned OFF.

In order to avoid the false problems mentioned above, a threshold level for generating alert indication 260 in Fig. 2 is properly determined. One hand, the threshold is determined to be at a level of being sufficiently higher than a noise signal level. On the other hand, the threshold is determined to be at a level of being sufficiently lower to maintain a proper sensitivity for the impulse responses.

Fig. 22 describes exemplary impulse detector 2200, such impulse detector 220 shown in Fig. 2, in a form of schematic diagram. Impulse detector 2220 includes analog-to-digital converter (ADC) 2210 and preconditioning circuit 2220. ADC 2210 generates alert indication 260 in response to output signal 2217 of preconditioning circuit 2220 when output signal 2217 exceeds a threshold level.

ADC 2210 is coupled, in signal communication, to microcontroller 240 and RFID chip 230 via a signal bus, such as I²C bus. The threshold level is programmable. In other words, the threshold level can be determined by software for microcontroller 240. For example, ADC081C021 available from Texas Instruments™ may be used as ADC 2210. ADC081C021 supports I²C bus with standard (200KHz), fast (400KHz), and high speed (3.4MHz) modes of operations.

Preconditioning circuit 2220 is coupled, in signal communication, between input point 2201 of preconditioning circuit 2220 and input point 2219 of ADC 2210. Input point 2201 of preconditioning circuit 2220 receives the impulse responses captured by FLEX antenna 220. Preconditioning circuit 2220 processes the impulse responses so that the natures of such responses may accurately be detected by ADC 2210.

More specifically, preconditioning circuit 2220 exhibits at least the following three functions: (1) to expand a duration time of the impulse response to a length suitable for an accurate detection of a change of the power state by ADC 2210; (2) to expand a magnitude of the impulse response in order to improve the overall noise immunity of ADC 2210, and (3) to enhance an overall operation of impulse acquisition circuitry 270 in accurately determining the difference between the two different impulse responses (i.e., a switch-ON impulse response and a switch-OFF impulse response).

Preconditioning circuit 2220 includes input point 2201, which is operative to receive an impulse response from FLEX antenna 220, and output point 2213 for providing ADC 2210 with a preconditioned (i.e. processed) version of the impulse response. Preconditioning circuit 2220 further includes first capacitor 2223, second capacitor 2228, first diode 2226, second diode 2227, and register 2222. A surface-mount Schottky Barrier diode, such as HSMS-2811 available from Agilent Technologies, may be used for first and second diodes 2226 and 2227.

Second capacitor 2228 is coupled to the anode of second diode 2227 and to the cathode of first diode 2226. Second capacitor 2228 and second diode 2227 coupled in series are coupled between input point 2201 and output point 2213 of preconditioning circuit 2220 (i.e., input point 2219 of DAC 2210). First diode 2226 is coupled between signal node 2211 and point 2215 of reference potential. The anode of first diode 2226 is coupled to point 2215 of reference, and the cathode of first diode 2226 is coupled to signal node 2211. Signal node 2211 is positioned between capacitor 2228 and the anode of diode 2227.

Capacitor 2223 is coupled between output point 2213 and point 2215 of reference potential. Output point 2213 is positioned between the cathode of second diode 2227 and output point 2213 (i.e., input point 2219 of ADC 2210). Resistor 2222 (R) is coupled between output point 2213 and point 2215 of reference potential. A value of first capacitor 2223 is substantially identical to a value of second capacitor 2228. A combination of first capacitor 2223 and resistor 2222 provide a time constant in order for ADC 2220 to respond to the switch-ON and switch-OFF impulse responses distinctively.

A proper time constant for a combination of first capacitor 2223 and resistor 2222 is determined. The time constant is high enough to detect accurately a single impulse waveform of a switch-ON impulse response in a period of time while being low enough to detect accurately at least two of the consecutive impulse waveforms of a switch-OFF impulse response in a period of time. Such a time constant value makes it possible for impulse acquisition circuitry 270 in Fig. 2 to distinguish accurately between the switch-ON and switch-OFF impulse responses with a simple algorithm. The time constant is also determined to avoid a false positive problem, described above.

Here, an exemplary operation of precondition circuit 2220 is described. During a negative half-cycle of an impulse response, first diode 2226 is bypassed and second capacitor 2228 is charged up to a peak voltage value of the impulse response. Then, during the following positive half-cycle, the peak voltage value is added to the voltage across second capacitor 2228 to charge first capacitor 2223. Second diode 2227 prevents first capacitor 2223 from discharging. In such a way, a voltage appears at output point 2213 (i.e., input point 2219 of ADC 2220) exceeds a peak voltage value of the impulse response. A maximum peak amplitude with a shortest time response is obtained when the value of first capacitor 2223 is equal to the value of second capacitor 2228-for example, one hundred pico-farad (100 pF) for each one of first and second capacitors 2223 and 2228.

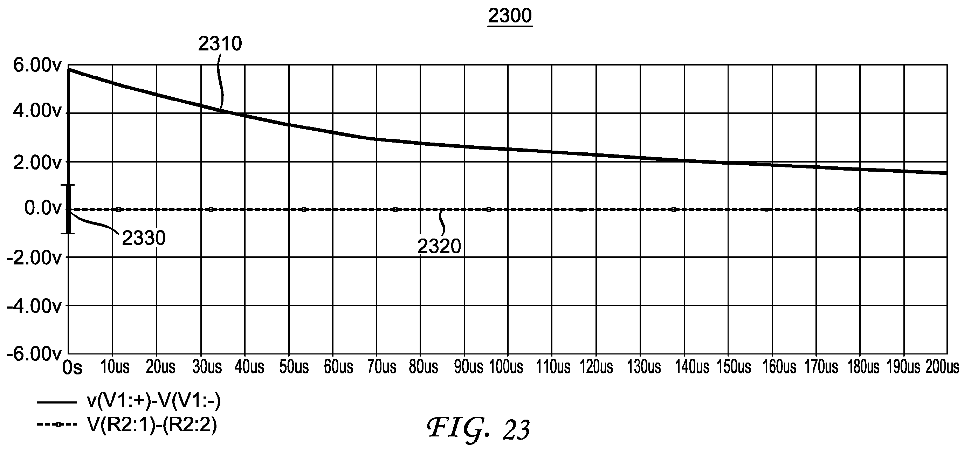

Fig. 23 illustrates an operation of preconditioning circuit 2220 in Fig. 22, based on a computer simulation. Response curve 2310 represents output signal 2217 of preconditioning circuit 2220, and an impulse response to preconditioning circuit 2220 is represented as line 2320. Impulse waveform 2330 may be observed as what appears to be a tiny vertical line at the left edge of Fig. 23.

In this computer simulation, a common value for each one of first and second capacitors 2223 and 2228 is set to be one hundred pico-farads (100 pF). The value of resistor 2222 is set to be one mega-ohms (1 MΩ) in order to obtain a discharging time constant of one hundred micro-second (100 µs). An optimal resistance value of one mega-ohms (1 MΩ) is determined based upon an assumption, in which a repetition period of a plurality of waveforms in the switch-OFF impulse response is two hundred microseconds (200 µs).

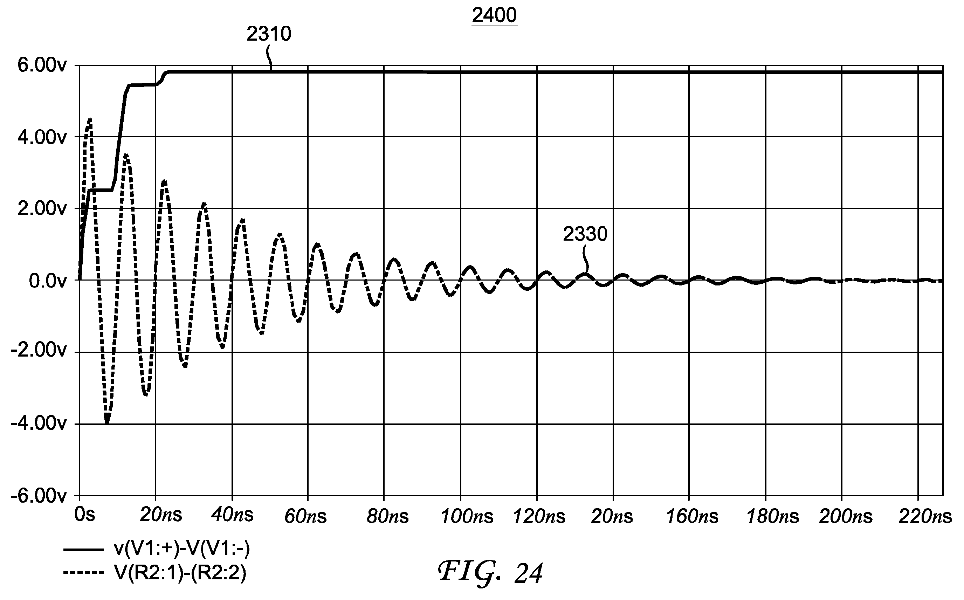

Fig. 24 illustrates enlarged view 2400 of an area in the vicinity of impulse waveform 2330 shown in Fig. 23, based upon a computer simulation. Here, single damped quasi-sinusoidal waveform 2330 is clearly shown, which waveform tends to be fading away toward zero (0).

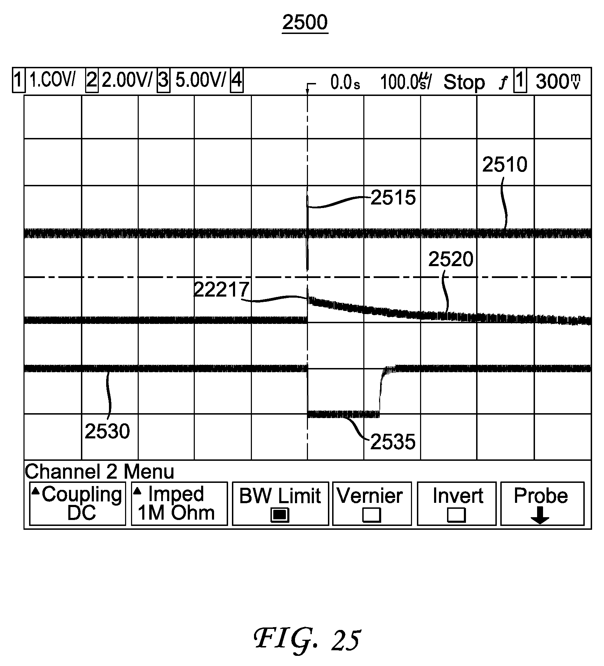

Fig. 25 illustrates an exemplary overall operation of impulse detector 2200 in Fig. 22 based on a measurement, to which an enhancement is added for better representation. Upper signal line 2510 represents an impulse response. Here, a single impulse waveform 2515 in the impulse response is received at input point 2201 of preconditioning circuit 2220. Middle signal line 2520 represents output signal 2217 of preconditioning circuit 2220, which is applied to input 2219 of ADC 2210. Signal 2520 is a preconditioned (i.e., processed) signal provided by preconditioning circuit 2220 from impulse waveform 2515. Lower signal line 2530 represents the alert indication output of ADC 2210. Rectangular signal 2535 is generated by ADC 2210 as alert indication 260 in response to output signal 2217.

More specifically, impulse waveform 2515 is applied to signal input 2201 of preconditioning circuit 2220. Output point 2213 of preconditioning circuit 2220 provides output signal 2217 to input point 2219 of ADC 2210 in response to impulse waveform 2515. Output signal 2217 is detected by ADC 2210, and ADC 2210 generates rectangular signal 2535 as alert indication 260 in response to a detection of signal 2217.

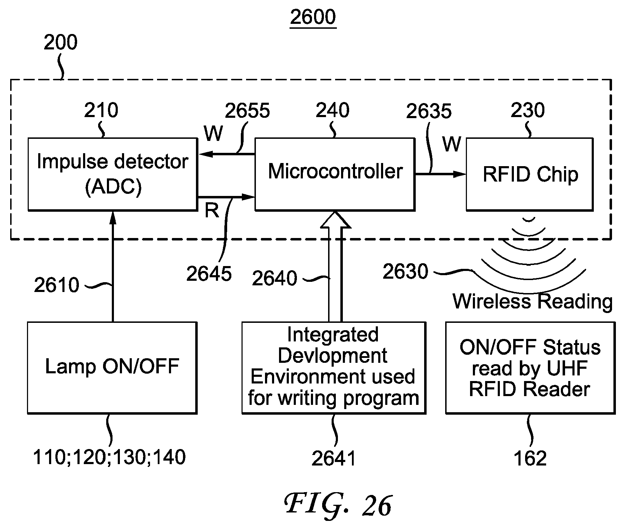

Fig. 26 illustrates an exemplary overall operation of electrical activity sensor unit 2600-such the one described as 112, 122, 132, or 142 in Fig. 1-in a form of functional block diagram. An electrical device, such as a lamp, may be turned ON and turned OFF during its normal operations. Each one of the power OFF-to-ON and power ON-to-OFF operations causes a distinctive pattern of impulse response, such as the ones shown in Figs. 17 and 18, to emerge on the power cable. The power cable provides an operating power to the electrical device.

This impulse response is captured by FLEX antenna 220 and is then detected by impulse detector 210. Impulse detector 210 is coupled in signal communication to microprocessor 240 and RFID chip 230 via a signal bus, such as I²C bus. Impulse detector 210 and microcontroller 240 operate together to determine a nature of such an impulse response (i.e., whether a switch-ON response or a switch-OFF response).

When a change of power state of the electrical device is detected by impulse detector 210, as indicated arrow 2610, microcontroller 240 updates a power status data stored in a memory (not shown) associated with RFID chip 230. This updated status data is then transmitted wirelessly to RFID reader 162 via FLEX antenna 220 in a band of UHF frequencies, as indicated wireless reading 2630. Microcontroller 240 executes an algorithm, provided as a form of software, operative to determine of the nature of the impulse response. The software is installed in a memory (not shown) associated with microcontroller 240 as indicated arrow 2640.

More specifically, when microcontroller 240 reads alert indication 260 generated by impulse detector 210, as indicated arrow 2645, microcontroller 240 writes an identification code to RFID chip 230, as indicated arrow 2635. The written identification code can be read wirelessly by RFID reader 162.

An entire process of sensor unit 200 (including reading an alert indication from impulse detector 210 to writing a status data for RFID chip 230) is controlled by microcontroller 240 as illustrated in Fig. 2. A plurality of individual electrical devices 110, 120, 130, 140 may be monitored with respective ones of a plurality of different identification codes as illustrated in Fig. 1.

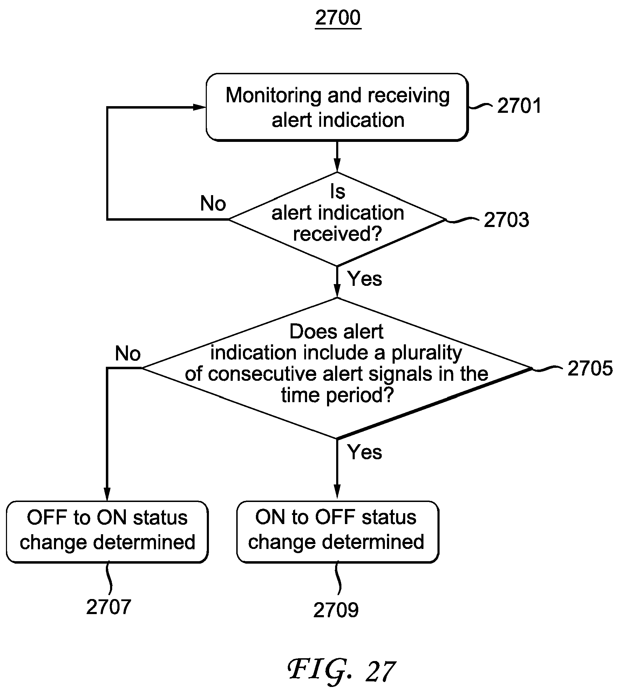

Fig. 27 illustrates, in a form of flow chart, exemplary process 2700 operative to determine a nature of alert indication 260 (i.e., whether a switch-ON alert or a switch-OFF alert) generated by impulse detector 210. At step 2810, microcontroller 240 monitors alert indication 260 generated by impulse detector 210. Alert indication 260 includes either a single alert signal or a plurality of consecutive alert signals in a time period. At step 2703, microcontroller 240 determines whether alert indication 260 is received. If no alert indication is received, microcontroller 240 keeps monitoring alert indication 260. If alert indication 260 is received, then at step 2705, microcontroller 240 analyzes a nature of such an alert indication. At step 2707, microcontroller 240 determines that alert indication 260 indicates a switch-ON operation (i.e., an OFF-to-ON state change) when a single alert signal is provided by impulse detector 210 within a time period. On the other hand, at step 2709, microcontroller 240 determines that alert indication 260 indicates a switch-OFF operation (an ON-to-OFF state change) when a plurality of consecutive alert signals are provided by impulse detector within a time period.

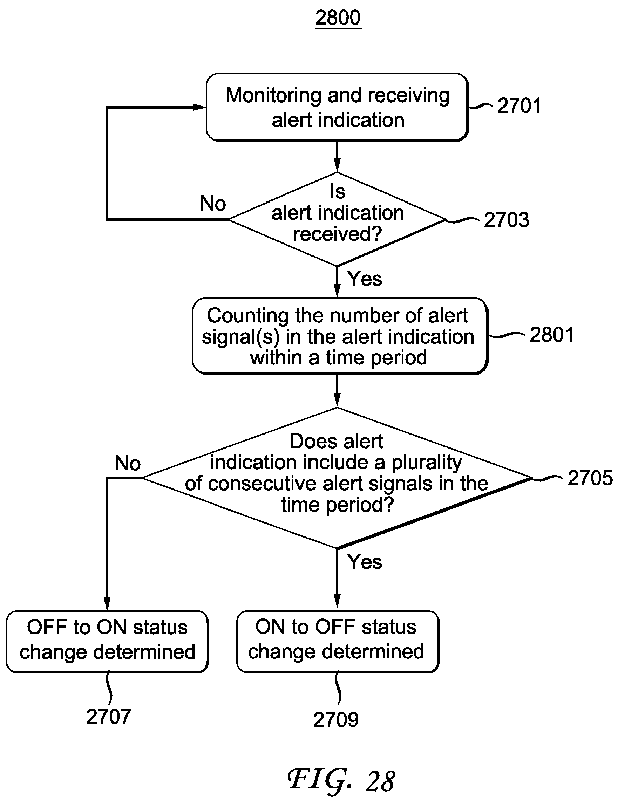

Fig. 28 illustrates, in a form of flow chart, exemplary process 2800 operative to determine a nature of alert indication 260 generated by impulse detector 210. The process 2800 includes additional step 2801 to process 2700 disclosed in Fig. 27. More specifically, at additional step 2801, microcontroller 240 counts a total number of the alert signals included in alert indication 260.

For monitoring a change of the power state, a software program is developed using a C++ platform. The program is first downloaded into a memory (not shown) associated with microcontroller 240, as shown in allow 2740 in Fig. 27. Here, a compatible Integrated Development Environment (IDE), such as an IDE available from Microchip Technology Inc., is used. Then the downloaded program may be either initialized or stopped with an operating power supplied from battery 250 in Fig. 2.

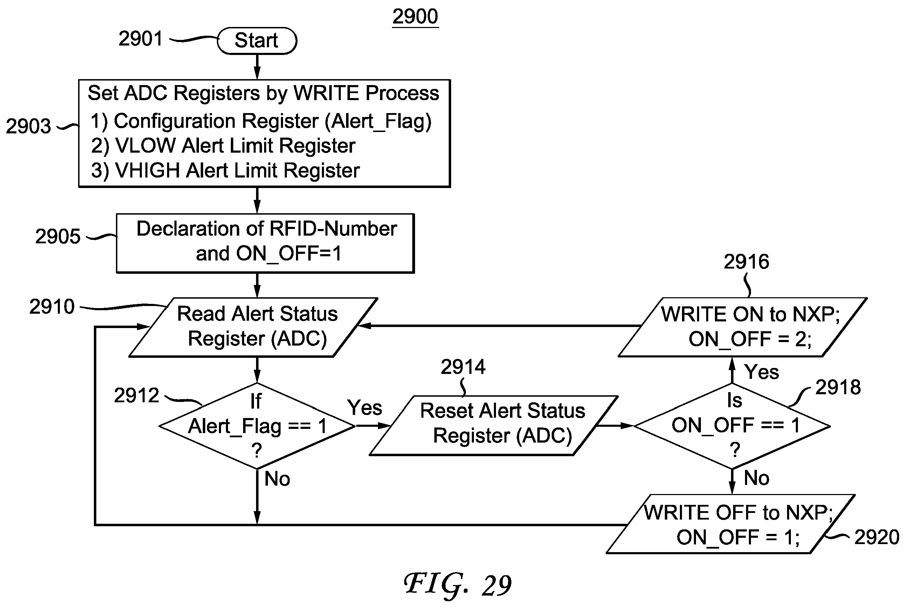

Fig. 29 illustrates an exemplary implementation 2900 of part of process 2700 disclosed in Fig. 27 in a form of flowchart. The software implementation 2900 describes a process for determining a change of the power status only. In other words, software implementation 2900 does not include a process for determining a nature of such a change (i.e., whether an OFF-to-ON change or an ON-to-OFF change).

More specifically, at step 2903, microcontroller 240 sets an alert flag for impulse detector 2200 in Fig. 22 by writing a configuration register of ADC 2210 in order to detect an impulse response, as shown by arrow 2655 in Fig. 26. Furthermore, a voltage threshold level is provided for an activation of the alert flag. Here, the alert flag is activated only if the received impulse response has a higher voltage than the voltage threshold level. At step 2910, microcontroller 240 reads the activated flag status, using the I²C protocol.

A power state of an electric device (i.e., either an "ON" state or an "OFF" state) is assigned to the activated flag status of "high." At step 2916 or 2920, microcontroller 240 writes such a power state in RFID 230 via I²C bus 290. At step 2914, before the power state is written in RFID 230, microcontroller 240 resets the alert flag by writing the configuration register. This facilitates a monitoring operation of the change on the power state.

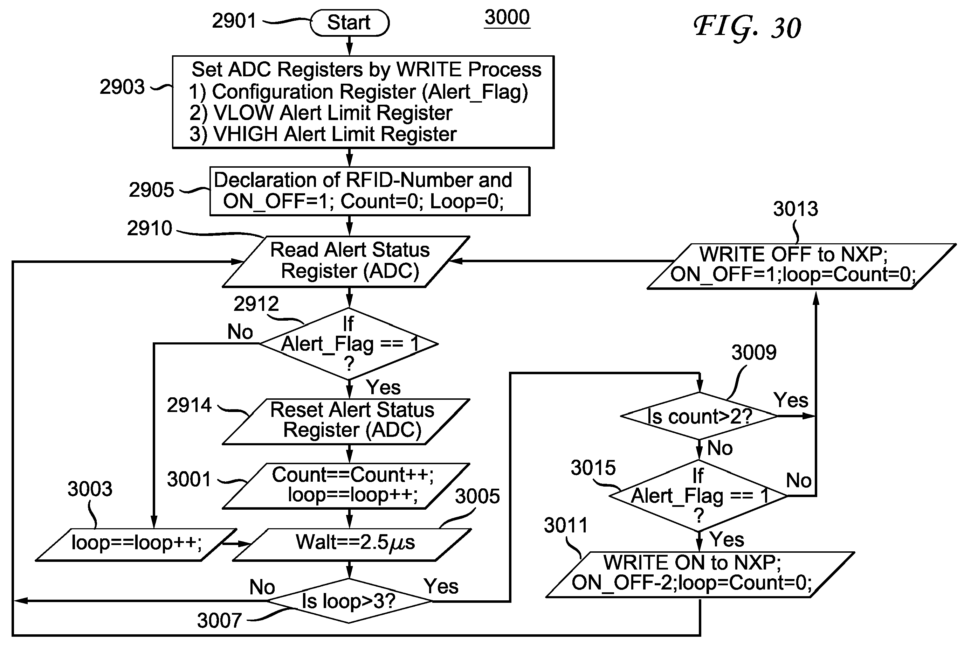

Fig. 30 illustrates an exemplary implementation of the process disclosed in Fig. 28, in a form of flowchart. The software implementation 3000 describes a process for determining not only a change of the power status but also a nature of such a change (i.e., whether an OFF-to-ON change or an ON-to-OFF change).

The nature of the change on the power state is determined based on the fact that a single waveform emerges in an impulse response when the power state changes from an OFF state to an ON state while a plurality of impulse waveforms emerge when the power state changes from an ON state to an OFF state, as illustrated in Figs. 17 and 18. In this embodiment, impulse detector 210 provides microcontroller 240 with a single alert signal in response to a corresponding single impulse waveform when the single impulse waveform is detected; impulse detector 210 provides a plurality of alert signals in response to respective ones of a corresponding plurality of impulse waveforms when the plurality of impulse waveforms are detected.

At step 3005, each one of a plurality of alert signals is counted every twenty-five micro-second (25 µs). At step 3007, a time period for analyzing an alert indication is set by a total number of the loop repetitions in the algorism, such as three.

Although the present invention has been described hereinabove with reference to specific embodiments, the present invention is not limited to the specific embodiments, and modifications will be apparent to a skilled person in the art which lie within the scope of the present invention.

For instance, while the foregoing examples have been described primarily with respect to a household power network system, it will be appreciated that embodiments of the invention may be applied to any power network to which electrical devices are connected. Moreover, the system could be applied in security or safety applications to identify electrical devices which have been switched ON or switched OFF.

Many further modifications and variations will suggest themselves to those versed in the art upon making reference to the foregoing illustrative embodiments, which are given by way of example only and which are not intended to limit the scope of the invention, that being determined solely by the appended claims. In particular the different features from different embodiments may be interchanged, where appropriate.

While several embodiments have been described and illustrated herein, those of ordinary skill in the art will readily envision a variety of other means and/or structures for performing the functions and/or obtaining the results and/or one or more of the advantages described herein, and each of such variations and/or modifications is deemed to be within the scope of the present embodiments. More generally, those skilled in the art will readily appreciate that all parameters, dimensions, materials, and configurations described herein are meant to be exemplary and that the actual parameters, dimensions, materials, and/or configurations will depend upon the specific application or applications for which the teachings herein is/are used.

## Claims

1. An apparatus comprising:
an impulse detector (210); and
a microcontroller (240), said microcontroller coupled in signal communication to said impulse detector (210);
said impulse detector (210) operative to receive an impulse response from an antenna (220),
said impulse detector (210) operative to provide one of a single alert signal and a plurality of alert signals for said microcontroller (240) in response to said impulse response, said impulse response including one of a single impulse waveform and a plurality of impulse waveforms in a time period,
said impulse detector (210) generating said single alert signal when said impulse response includes said single impulse waveform, said impulse detector (210) generating said plurality of alert signals when said impulse response includes respective ones of said plurality of impulse waveforms,
said microcontroller (240) operative to determine a nature of said impulse response, said nature being determined as a switch-ON response when said single alert signal is received, said nature being determined as a switch-OFF response when said plurality of alert signals are received.

2. The apparatus of the Claim 1, wherein
said impulse detector (210) includes a circuit (2220) and an analog-to-digital converter (2210), said circuit (2220) has a first input point (2201) operative to receive said impulse response from said antenna (220), said analog-to-digital converter (2210) has a second input point (2219);
said circuit (2220) is coupled between said first input point (2201) and said second input point (2219), said circuit (2220) includes a first capacitor (2223), a second capacitor (2228), a first diode (2226), a second diode (2227), and a resister (2222);
said second capacitor (2228) and said second diode (2227) coupled in series are coupled between said first input point (2201) and said second input point (2219), said first diode (2226) is coupled between a first node (2221) and a point of reference potential (2215), said first node (2221) is between said second capacitor (2228) and said second diode (2227), said first capacitor (2223) is coupled between a second node (2213) and said point of reference potential (2215), said second node (2213) is between said second diode (2227) and said second input point (2219), said resistor (2222) is coupled between said second node (2213) and said point of reference potential (2215); and
a first value of said first capacitor (2223) is substantially identical to a second value of said second capacitor (2228), said first capacitor (2223) and said resistor (2222) provide a time constant in order for said analog-to-digital converter (2210) to respond to at least one of said switch-ON impulse response and said switch-OFF impulse response distinctively.

3. The apparatus of the Claim 1, wherein
said impulse detector (210) and said microcontroller (240) are coupled in signal communication via an I²C bus.

4. The apparatus of the Claim 1, wherein
said antenna (220) is a FLEX antenna.

5. The apparatus of the Claim 2, wherein
at least one of said first diode and said second diode is a Schottky Barrier diode.

6. A method comprising:
receiving (2801) an alert indication (260) from an impulse detector (210), said alert indication (260) including one of a single alert signal and a plurality of alert signals in a time period;
analyzing (2805) a nature of said alert indication (260);
first determining (2807) said nature as a switch-ON alert indication if a single alert signal is received;
second determining (2809) said nature as a switch-OFF alert indication if a plurality of alert signals are received; and
transmitting the determined nature to an RFID chip (230) via a signal bus (290).

7. The method of the Claim 6 wherein:
said analyzing (2805) step includes counting (2901) a number of alert signals in said time period.

8. The method of Claim 6 wherein:
said signal bus (290) is an I²C bus.

9. The method of Claim 7 wherein:
said signal bus (290) is an I²C bus.

10. An apparatus comprising:
first means (210) for detecting an impulse response; and
second means (240) coupled in signal communication to said first means (210) for controlling said first means (210),
said first means (210) receiving said impulse response from an antenna (220),
said first means (210) providing one of an alert signal and a plurality of alert signals for said second means (240) in response to said impulse response, said impulse response including one of a single impulse waveform and a plurality of impulse waveforms in a time period,
said first means (210) generating said single alert signal when said impulse response includes said single impulse waveform, said first means (210) generating said plurality of alert signals when said impulse response includes respective ones of said plurality of impulse waveforms,
said second means (240) determining a nature of said impulse response, said nature being determined as a switch-ON response when said single alert signal is received, said nature being determined as a switch-OFF response when said plurality of alert signals are received.

11. The apparatus of the Claim 10, wherein
said first means (210) includes third means (2220), said third means (2220) has a first input (2201) for receiving said impulse response from said antenna (220), said first means (210) further includes fourth means (2210) for generating said one of said alert signal and said plurality of alert signals, said fourth means (2210) has a second input point (2219);
said third means (2220) is coupled between said first input point (2201) and said second input point (2219), said third means (2220) includes a first capacitor (2223), a second capacitor (2228), a first diode (2226), a second diode (2227), and a resister (2222);
said second capacitor (2228) and said second diode (2227) coupled in series are coupled between said first input point (2201) and said second input point (2219), said first diode (2226) is coupled between a first node (2221) and a point of reference potential (2215), said first node (2221) is between said second capacitor (2228) and said second diode (2227), said first capacitor (2223) is coupled between a second node (2213) and said point of reference potential (2215), said second node (2213) is between said second diode (2227) and said second input point (2219), said resistor (2222) is coupled between said second node (2213) and said point of reference potential (2215); and
a first value of said first capacitor (2223) is substantially identical to a second value of said second capacitor (2228), said first capacitor (2223) and said resistor (2222) provide a time constant in order for said fourth means (2210) to respond to at least one of said switch-ON impulse response and said switch-OFF impulse response distinctively.

12. The apparatus of the Claim 10, wherein
said first means (210) and said second means (240) are coupled in signal communication via an I²C bus.

13. The apparatus of the Claim 10, wherein
said antenna (220) is a FLEX antenna.

14. The apparatus of the Claim 11, wherein
at least one of said first diode and said second diode is a Schottky Barrier diode.
